# EUROPEAN PATENT APPLICATION

(11) **EP 0 948 249 A2**
(43) Date of publication of application: **06.10.1999**
(21) Application number: 99302447.0
(22) Date of filing: 29.03.1999
(51) Int. Cl.: H05K 7/20

(54) **Numerical control apparatus**

(30) Priority: 30.03.1998 JP 9996398
(71) Applicant: FANUC LTD, Minamitsuru-gun, Yamanashi 401-05 (JP)
(72) Inventor: Noda, Hiroshi, Minamitsuru-gun, Yamanashi, 401-0511 (JP); Otsuki, Hideki, Minamitsuru-gun, Yamanashi, 401-0511 (JP)
(74) Representative: Billington, Lawrence Emlyn

(57) **Abstract**

A numerical control apparatus comprises a controller and a back case containing a battery and/or a fan motor. The tip end of a cable laid from the battery and/or fan motor is electrically connected to a printed board disposed on the back case, and a connector is provided to detachably connect the printed board to the controller.

## Description

### 1. Field of the Invention

The present invention relates to a numerical control apparatus.

### 2. Description of the Related Art

Generally, the numerical control apparatus comprises a controller and a back case, and is configured so that the back case contains fan motors with a cooling fan for cooling the controller and a battery for backing up a volatile memory in a control circuit, the battery being connected to the control circuit and each of the fan motors being connected to a power supply terminal on the side of the controller.

Conventionally, in order to connect the fan motors and the battery to the controller, the tip ends of a plurality of cables laid from the fan motors and the battery are connected one by one to the terminals provided on the controller.

Therefore, in the case where the controller is separated from the back case when maintenance work is performed and it is connected to the back case after the maintenance work is finished, the plurality of cables must be removed from the controller one by one and must be connected again. This work not only is troublesome and time-consuming, but also may cause mistaken connection of cables.

An object of the present invention is to provide a numerical control apparatus in which a controller and a back support can easily be separated from and connected to each other, and mistaken connection of the cables is not caused at the time of re-connection.

The numerical control apparatus in accordance with the present invention, having a display section, a control section disposed on the back surface of the display section, and a back support, which is disposed on the back surface of the control section, for supporting a battery and/or a fan motor, is characterized in that a connection is used to connect a cable laid from the battery and/or fan motor to the control section.

In one embodiment, the apparatus is characterised in that the tip end of the cable laid from the battery and/or fan motor is electrically connected to a printed board disposed on the back support, and a connector or a connecting cable is used to connect the printed board to the control section.

In another embodiment, the numerical control apparatus in accordance with the present invention, having a display section, a control section disposed on the back surface of the display section, and a back support, which is disposed on the back surface of the control section, for supporting a battery and a cableless fan motor, is characterized in that the battery is connected to the control section by using a cable, the cableless fan motor is mounted on a parts mounting wiring board provided in the back support, and a connector is used to connect the parts mounting wiring board to the control section.

In a yet further embodiment, the numerical control apparatus in accordance with the present invention, having a display section, a control section disposed on the back surface of the display section, and a back support, which is disposed on the back surface of the control section, for supporting a cableless battery and a cableless fan motor, is characterized in that the cableless battery and the cableless fan motor are mounted on a parts mounting wiring board provided in the back support, and a connector is used to connect the parts mounting wiring board to the control section.

According to the numerical control apparatus in accordance with the present invention, the controller can be connected to or separated from the back case without attaching or detaching the cables laid from the battery and/or fan motor contained in the back case to or from the controller one by one. Therefore, the maintenance work can be performed very easily, and moreover there is no fear of causing mistaken connection of cables when the controller is installed in the back case again.

The foregoing and other objects and features of the invention will become apparent from the following description of preferred embodiments of the invention with respect to the accompanying drawings, in which:
Fig. 1 is a sectional view of the numerical control apparatus in accordance with a first embodiment of the present invention;
Fig. 2 is a sectional view of the numerical control apparatus in accordance with a second embodiment of the present invention;
Fig. 3 is a side view of a principal portion of the numerical control apparatus shown in Fig. 2;
Fig. 4 is a sectional view of the numerical control apparatus in accordance with a third embodiment of the present invention;
Fig. 5 is a sectional view of the numerical control apparatus in accordance with a fourth embodiment of the present invention;
Fig. 6 is a sectional view of the numerical control apparatus in accordance with a fifth embodiment of the present invention; and
Fig. 7 is a perspective view of a principal portion of the numerical control apparatus shown in Fig. 6.

### DETAILED DESCRIPTION OF THE PREFERRED EMBODIMENTS

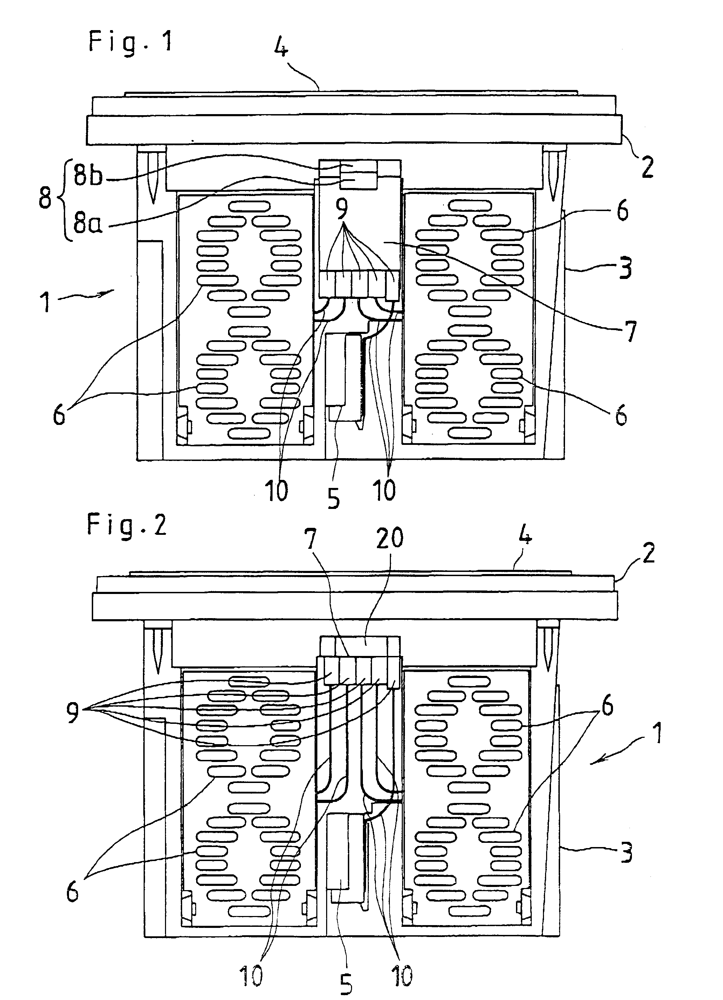

Fig. 1 shows a first embodiment of the present invention.

A numerical control apparatus 1 has a controller 2 and a back support comprising a back case 3 installed at the back of the controller 2. On the surface of the controller 2 is provided a liquid crystal display device 4.

The back case 3 contains a battery 5 for backing up a volatile memory in a control circuit of the controller 2 and fan motors 6 with a cooling fan for dissipating heat generated during the operation of the controller 2. Although four fan motors 6 are contained in an example shown in Fig. 1, any other number of fan motors may be contained.

Also, on the surface of the back case 3 is disposed a printed board 7, and at opposed positions of the printed board 7 and the controller 2 are mounted one side member 8a and the other side member 8b of a connector 8 which are detachably engaged with each other in a mortise joint manner and electrically connected to each other, respectively.

Further, the printed board 7 is provided with parts connecting connectors 9 corresponding to the battery 5 and the fan motors 6, and the tip ends of cables 10 laid from the battery 5 and the fan motors 6 can be electrically connected to these parts connecting connectors 9.

Therefore, when the tip ends of the cables 10 are connected to the parts connecting connectors 9, and the one side member 8a of the connector 8 mounted on the printed board 7 is engaged with the other side member 8b of the connector 8 mounted on the controller 2, the battery 5 and the fan motors 6 are electrically connected to the control circuit and power supply terminals of the controller 2, respectively, via the printed board 7.

In this case, merely by disengaging the connector 8, the controller 2 can be separated from the back case 3 without pulling the cables 10 out of the parts connecting connectors 9.

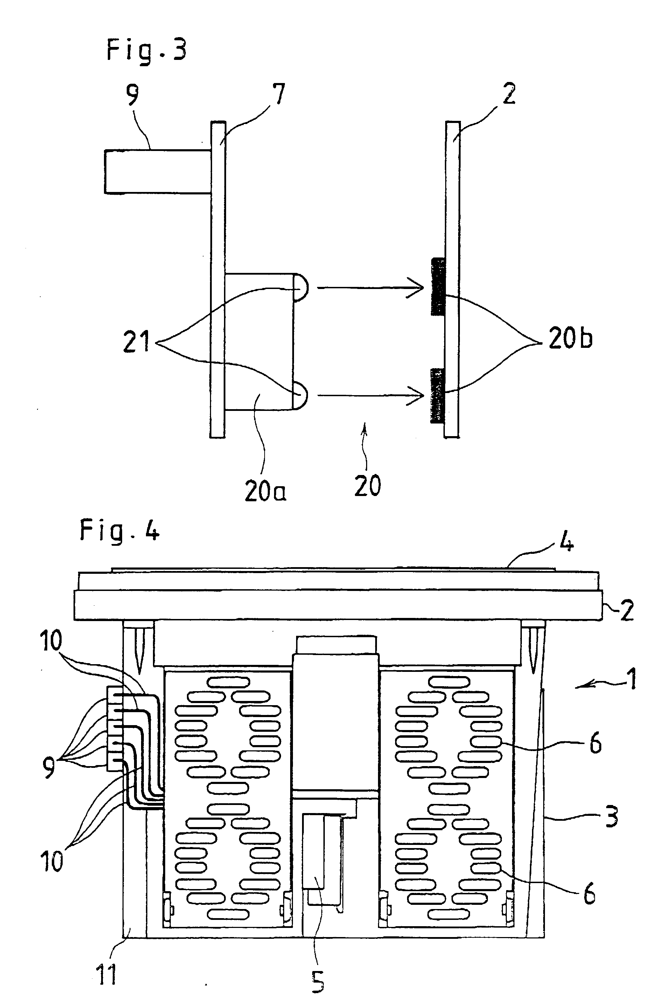

Also, as shown in Figs. 2 and 3, a connector 20 of a pressure connecting type can be used in place of the connector 8 of a mortise engagement type.

As shown in Fig. 3, pressure connecting terminals 21 are provided projectingly on one side member 20a of the connector 20 mounted in front of the printed board 7, and the other side members of the connector 20, comprising pressed pads 20b having conductivity, are mounted at positions opposed to the pressure connecting terminals 21 on the back surface of the controller 2.

Therefore, when the back case 3 is installed to the controller 2, the pressure connecting terminals 21 are pressed on the pressed pads 20b, and thereby the printed board 7 is connected electrically to the controller 2.

Since other configurations are the same as those of the embodiment shown in Fig. 1, the same reference numerals are applied to the same elements, and the explanation thereof is omitted.

Fig. 4 shows a third embodiment of the present invention.

An extension printed board 11 having an added function is detachably inserted in the back case 3, and a connector (not shown), which is detachably connected to each other, is provided at the opposed positions of the controller 2 and the extension printed board 11. This connector may be of a mortise engagement type or may be of a pressure connecting type.

When the extension printed board 11 is inserted in the predetermined position of the back case 3, the connector is automatically connected, so that the extension printed board 11 is electrically connected to the controller 2, and thereby other functions, which the controller 2 does not have inherently, can be added.

The extension printed board 11 is provided with the parts connecting connectors 9 for electrically connecting the tip ends of the cables 10 laid from the battery 5 and the fan motors 6.

Therefore, when the tip ends of the cables 10 are connected to the parts connecting connectors 9 and then the extension printed board 11 is assembled into the back case 3, other functions are added to the controller 2, and at the same time the battery 5 and the fan motors 6 are connected to the controller 2.

Since other configurations are the same as those of the embodiment shown in Fig. 1, the same reference numerals are applied to the same elements, and the explanation thereof is omitted.

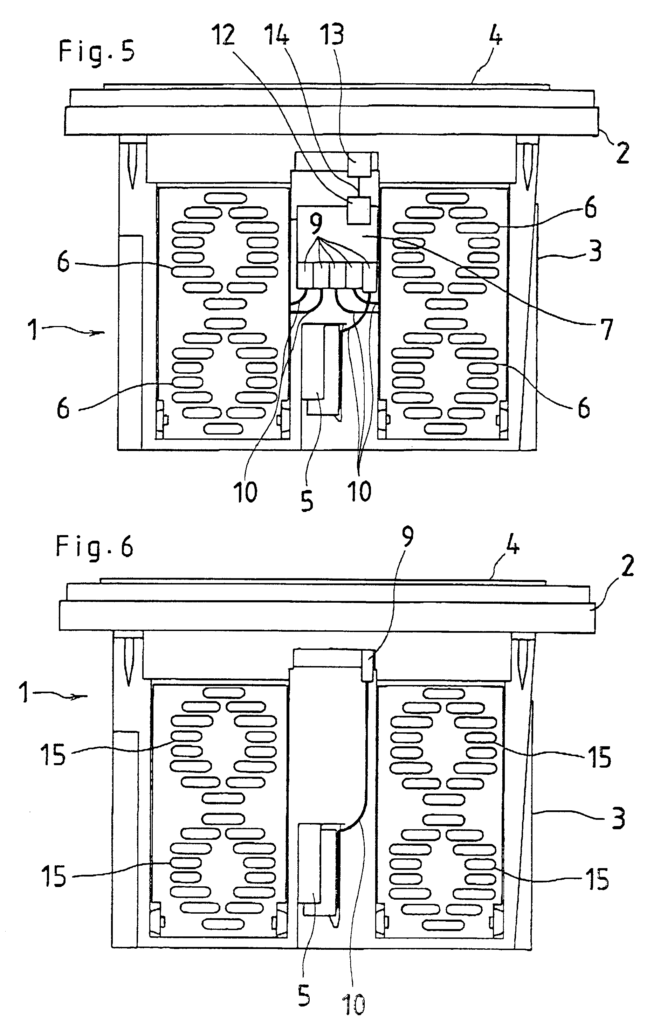

Fig. 5 shows a fourth embodiment of the present invention.

Connecting cable connectors 12 and 13 are mounted to the printed board 7 and the controller 2, respectively, and the opposite ends of a connecting cable 14 are electrically connected to these connecting cable connectors 12 and 13, by which the printed board 7 is connected to the controller 2.

Therefore, merely by attaching or detaching one connecting cable 14, the controller 2 can be connected to or separated from the back case 3.

Since other configurations are the same as those of the embodiment shown in Fig. 1, the same reference numerals are applied to the same elements, and the explanation thereof is omitted.

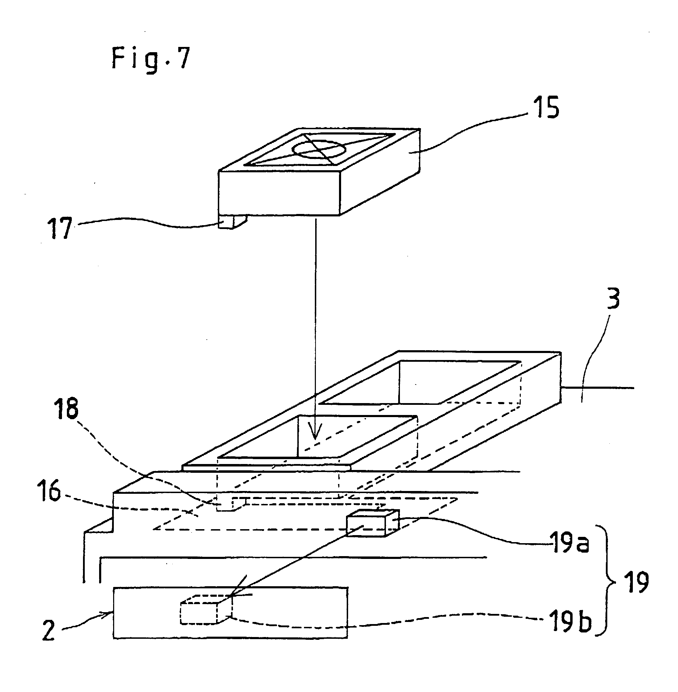

Figs. 6 and 7 show a fifth embodiment of the present invention.

The back case 3 contains the battery 5, a plurality of (four in the example shown in the figures) cableless fan motors 15 not requiring a power supply cable, and a parts mounting wiring board 16 for supporting all of the cableless fan motors 15.

Also, the cable 10 laid from the battery 5 is connected to the controller 2 via the connector 9.

As shown in Fig. 7, the cableless fan motors 15 each have a terminal pin 17, and a parts mounting wiring board 16 is formed with terminal holes 18 for inserting and connecting the terminal pins 17.

Also, one side member 19a and the other side member 19b of a connector 19, which are detachably connected to each other, are mounted to opposed positions of the parts mounting wiring board 16 and the controller 2, respectively. This connector 19 may be of a mortise engagement type or may be of a pressure connecting type.

Consequently, when the parts mounting wiring board 16 is contained in the predetermined position of the back case 3 and the controller 2 is installed in the back case 3, the connector 19 is automatically connected so that the cableless fan motors 15 are connected electrically to the controller 2.

Merely by removing one cable 10 laid from the battery 5 and disengaging the connector 19, the controller 2 can be separated from the back case 3.

The configuration may be such that the battery is a cableless battery not requiring a power supply cable with a terminal pin being provided, and a terminal hole for inserting the terminal pin of the battery is formed in the parts mounting wiring board.

In this case, merely by attaching or detaching the connector mounted to the parts mounting wiring board and the controller, the controller can be connected to or separated from the back case without attaching or detaching the cable.

## Claims

1. A numerical control apparatus comprising a display section, a control section disposed on the back surface of said display section, and a back support, which is disposed on the back surface of said control section, for supporting a battery and/or a fan motor, wherein a connector is used to connect a cable laid from said battery and/or fan motor to said control section.

2. A numerical control apparatus comprising a display section, a control section disposed on the back surface of said display section, and a back support, which is disposed on the back surface of said control section, for supporting a battery and/or a fan motor, wherein the tip end of a cable laid from said battery and/or fan motor is electrically connected to a printed board disposed on said back support, and a connector is used to connect said printed board to said control section.

3. A numerical control apparatus comprising a display section, a control section disposed on the back surface of said display section, and a back support, which is disposed on the back surface of said control section, for supporting a battery and/or a fan motor, wherein the tip end of a cable laid from said battery and/or fan motor is electrically connected to a printed board disposed on said back support, and a connecting cable is used to connect said printed board to said control section.

4. A numerical control apparatus comprising a display section, a control section disposed on the back surface of said display section, and a back support, which is disposed on the back surface of said control section, for supporting a battery and a cableless fan motor, wherein said battery is connected to said control section by using a cable, and said cableless fan motor is mounted on a parts mounting wiring board provided in said back support, and a connector is used to connect said parts mounting wiring board to said control section.

5. A numerical control apparatus comprising a display section, a control section disposed on the back surface of said display section, and a back support, which is disposed on the back surface of said control section, for supporting a cableless battery and a cableless fan motor, wherein said cableless battery and said cableless fan motor are mounted on a parts mounting wiring board provided in said back support, respectively, and a connector is used to connect said parts mounting wiring board to said control section.

6. The numerical control apparatus according to any one of claims 1, 2, 4 and 5, wherein said connector is composed of a pressure connecting terminal and a pressed pad having conductivity.
